(19) Europäisches Patentamt / European Patent Office / Office européen des brevets

(11) **EP 2 894 762 B1**

(12) **EUROPEAN PATENT SPECIFICATION**

(45) Date of publication and mention
of the grant of the patent:
**04.10.2023 Bulletin 2023/40**

(21) Application number: **12884145.9**

(22) Date of filing: **05.09.2012**

(51) International Patent Classification (IPC):
**H02J 50/00** (2016.01)      **H05K 13/04** (2006.01)
**H02J 50/80** (2016.01)

(52) Cooperative Patent Classification (CPC):
**H02J 50/80; H05K 13/0885**

(86) International application number:
**PCT/JP2012/072634**

(87) International publication number:
**WO 2014/038018 (13.03.2014 Gazette 2014/11)**

(54) **NON-CONTACT POWER SUPPLY DEVICE**

KONTAKTFREIE STROMÜBERTRAGUNGSVORRICHTUNG

DISPOSITIF D'ALIMENTATION EN COURANT SANS CONTACT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**15.07.2015 Bulletin 2015/29**

(73) Proprietor: **FUJI Corporation
Chiryu
Aichi (JP)**

(72) Inventors:
• **SAITO, Masaru
Chiryu
Aichi (JP)**
• **NOMURA, Takeshi
Chiryu
Aichi (JP)**
• **ISHIURA, Naomichi
Chiryu
Aichi (JP)**

• **TAKIKAWA, Shinji
Chiryu
Aichi (JP)**

(74) Representative: **Grünecker Patent- und
Rechtsanwälte
PartG mbB
Leopoldstraße 4
80802 München (DE)**

(56) References cited:
**WO-A1-2010/122598        WO-A1-2011/043074
WO-A1-2012/070479        JP-A- H09 312 942
JP-A- H10 215 530        JP-A- 2012 070 614
JP-A- 2012 110 118        US-A1- 2012 038 218**

• **T. Bieler ET AL: "Contactless power and
information transmission", IEEE
TRANSACTIONS ON INDUSTRY
APPLICATIONS., vol. 38, no. 5, 1 September 2002
(2002-09-01), pages 1266-1272, XP055375338, US
ISSN: 0093-9994, DOI: 10.1109/TIA.2002.803017**

## Description

Technical Field

The present invention relates to a contactless electric power supply device that supplies power to a current consumer on a movable section from a fixed section in a contactless manner, in particular, it relates to a contactless electric power supply device that detects the operating condition of the current consumer at the fixed section side.

Background Art

For board manufacturing equipment for producing boards mounted with multiple components, there are solder printing machines, component mounters, reflow machines, board inspection machines and so on, and there are many cases in which these are configured into board producing lines by linking them with a board conveyance device. Many of these board manufacturing equipment are equipped with a movable section which performs work after moving to a specified position above the board, and a linear motor device can be used as a means for driving the movable section. A linear motor device is typically comprised of a track member with multiple magnets with alternating N poles and S poles arranged along the moving direction, and a movable section which includes an armature with a core and coil. In order to supply electricity to a current consumer on the movable section such as a linear motor device, a deformable cable for supplying electricity has been used. Also, in recent years, in order to reduce negative effects such as risks of disconnections from metal fatigue and the load weight capacity increasing due to power supply cables, contactless electric power supply devices have been proposed.

For the contactless electric power supply device method, an electromagnetic induction method using a coil has been used a lot, but recently electrostatic coupling methods using a capacitor configuration with opposing electrode plates have become used, and there are other methods such as magnetic field resonance and so on being evaluated. No matter the method used, it is important to increase the electric power supply efficiency, and technology for large current flows for series resonant circuits for the entire contactless electric power circuit, and technology to improve the impedance matching at the electric supply point and such have been proposed. In addition, for contactless electric power supply devices, in order to stably operate the current consumer on the movable section, there are many cases of variably adjusting the output voltage of the high-frequency power source circuit on the fixed section side.

A technological example of a contactless electric power supply device of this type is disclosed in Japanese Unexamined Patent Application Publication Number 2011-223739. The wireless electric power supply system of patent literature 1 is essentially designed to impedance match at the electric supply point and is applicable mostly for an electromagnetic resonance type (magnetic resonance type) contactless electric power supply device. In claim 1 of Japanese Unexamined Patent Application Publication Number 2011-223739, a form of electric power supply device which has an electric power generation section, power transmission element, impedance detection section of the electric power supply side, impedance variable force matching section, impedance characteristic memory section, and control section is disclosed, such that it is possible to variably adjust the output impedance of the electric power supply side. In addition, in claim 8, an electric power receiving device with an analogous configuration which variably adjusts the input impedance of the electric power receiving side is disclosed. Further, in claims 15 and 16, a form in which impedance control information is transmitted/received between the electric power supply device and electric power receiving device using a communication section is disclosed. From this, it is stated that the current loss can be reduced by both sides adjusting the impedance, and increases in the circuit scale and costs can be controlled.

A contactless electric power supply device according to the preamble of independent claim 1 is known from WO 2012/070479 A1.

A contactless electric power supply device for inductive power transfer, with contactless information transmission, is disclosed in T.Bieler ET AL: "Contactless power and information transmission", IEEE TRANSACTIONS ON INDUSTRY APPLICATIONS., vol. 38, no. 5, September 2002, pages 1266-1272, XP55375338, US ISSN: 0093-9994, DOI: 10.1109/TIA.2002.803017

Summary of invention

Problem to be Solved by the invention

Note that, for the system from patent literature 1, because contactless electric power supply is provided by the magnetic field resonance method for comparatively long distances, it is necessary to match the impedance. However, when providing contactless electric power supply over comparatively short distances by the electrostatic coupling method and electromagnetic induction method, it is conventional to raise the electricity power supply efficiency using series resonant circuits, but if the system from patent literature 1 is adopted, costs become comparatively high due to the excessive device configuration.

Conversely, the electric power supply efficiency changes depending on the operating condition of the current consumer for the electrostatic coupling method and electromagnetic induction method. It follows that, it is desirable to detect the operating condition of the current consumer and actual transmitted supplied electric power and so on, and based on this, variably control the output voltage of the high-frequency power source circuit for the electric power supply side. However, if the detection circuit and communication section analogous to that in patent literature 1 is provided in the electric power receiving side, by that amount the configuration of the electric power receiving side becomes more complex and more massive. Here, because the electric power receiving side is conventionally set on the movable section, the movable section weight and size becomes a big hindrance for reducing the supplied electric power amount and equipment costs and so on.

In addition, if the operating condition of the current consumer and actual transmitted supplied electric power is not detected, the contactless electric power supply condition becomes unknown and due to this, it is possible that the operation stability of the current consumer on the movable section is lowered, and operating speed is lowered.

The present invention has been made in consideration of the problems in the background art, and an object thereof is to provide a contactless electric power supply device in which, by detecting the operating condition of the current consumer on the movable section which is the target of the contactless electric power supply at the fixed section side, the operating stability of the current consumer is higher while simplifying the electric circuit on the movable section side, and the movable section is made smaller and lighter for reducing the supplied electric power and lowering equipment costs.

Means for Solving the Problem

The present invention of a contactless electric power supply device from claim 1 which solves the above problems is for capacitive power transfer and comprises: a contactless electric power supply element provided on a fixed section, a high frequency power source circuit for supplying high frequency power to the contactless electric power supply element, a contactless electric power reception element for receiving high frequency electric power in a contactless manner which is facing and separated from the contactless electric power supply element and which is provided on a movable section that is movably mounted on the fixed section, and an electric power reception circuit which supplies electric power to a current consumer on the movable section after converting the high-frequency power which the contactless electric power reception element received; and which further comprises a contactless transmitting element provided on the movable section which is electrically connected to the contactless electric power reception element, a contactless reception element provided on the fixed section which receives electric signals related to operating condition of the current consumer in a contactless manner and is facing and separated from the contactless transmitting element but is not electrically connected to the contactless electric power supply element so that it does not transmit the high-frequency electric power to the contactless transmitting element, and a detection circuit provided on the fixed section that detects the operating condition of the current consumer based on the electric signal and is electrically connected to the contactless reception element.

With respect to claim 1, the contactless electric power supply element, the contactless electric power reception element, the contactless transmitting element, and the contactless reception element can each be electrode plates.

For the invention from claim 2, with respect to claim 1, the contactless electric power reception element and the contactless transmitting element are integrated in one movable section side electrode plate.

For the invention from claim 3, with respect to claim 1 or 2, the detection circuit adjusts the output voltage of the high-frequency power source circuit based on the detected operating condition of the current consumer.

For the invention from claim 4, with respect to any of the claims from 1 to 3, a series resonant circuit for the output frequency of the high-frequency power source circuit is configured from the contactless electric power supply element, the contactless electric power reception element, the high-frequency power source circuit, and the electric power reception circuit.

For the invention from claim 5, with respect to any of the claims from 1 to 4, the movable section is provided in a component mounter for mounting components on a circuit board, and is further provided with a mounting head for performing component mounting actions.

Effects of the invention

In the present invention of a contactless electric power supply device from claim 1, an electric signal relating the operating condition of the current consumer is transmitted in a contactless manner from the contactless transmitting element on the movable section to the contactless reception element on the fixed section, and this is detected by the detection circuit on the fixed section. It follows that, the electric circuit on the movable section can be made simpler compared to a configuration in which the detection circuit and communication circuit are on the movable section, and the movable section can be lighter and more compact which can contribute to reducing the supplied electric power and lowering equipment costs.

In the present invention from claim 1, when each element is a respective electrode plate, and the electric signal related to the operating condition of the current consumer is transmitted from the movable section to the fixed section by electrostatic coupling. It follows that, that for the movable section, it is good to just add the electrode plate for contactless transmission to a conventional configuration, and the electric circuit can be made remarkably simpler compared to when the detection circuit and communication circuit are added.

For the invention from claim 2, the contactless electric power reception element and contactless transmitting element of the movable section are integrated, which reduces the number of parts and can contribute to reducing equipment costs largely.

For the invention from claim 3, the contactless electric power supply condition is stable because the detection circuit adjusts the output voltage of the high-frequency power source circuit based on the operating condition of the current consumer, sufficient electric power is supplied to the current consumer on the movable section and the stability of the operating condition is raised.

For the invention from claim 4, because a large electric current can flow for the power supply using a series resonant circuit, it is possible to maintain a large electric power supply even by supplying electric power in a contactless manner.

For the invention from claim 5, the movable section is provided in a component mounter, and is further provided with a mounting head for performing component mounting actions. The present invention of a contactless electric power supply device can be provided in a component mounter and the movable section with the mounting head can be more lightweight and compact. From this, the required electric power for the movable section becomes smaller and the electric power supplied by contactless electric power supply can be reduced, and this can contribute to a reduction in the equipment cost for component mounters.

Brief Description of Drawings

[FIG. 1]
This is a perspective view showing the overall configuration of a component mounter which can use the contactless electric power supply device of embodiment 1 of the present invention.

[FIG. 2]
This is a configuration diagram to illustrate schematically the contactless electric power supply device of embodiment 1.

[FIG. 3]
This is a diagram to illustrate the configured capacitor for transmitting electric power and the capacitor for receiving for embodiment 1.

[FIG. 4]
This is an equivalent circuit diagram for the contactless electric power supply device of embodiment 1.

[FIG. 5]
This is an equivalent circuit diagram for the resonance frequency of the contactless electric power supply device of embodiment 1.

[FIG. 6]
This is a configuration diagram to illustrate schematically the contactless electric power supply device of embodiment 2.

[FIG. 7]
This is a configuration diagram to illustrate conceptually the contactless electric power supply device of embodiment 3.

[FIG. 8]
This is a configuration diagram to exemplify conceptually a contactless electric power supply device using conventional technology.

Description of Embodiments

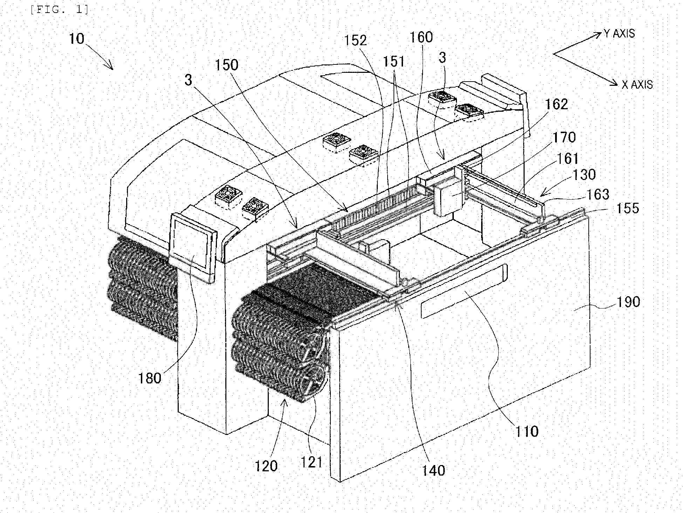

First, a component mounter 10 which can use the contactless electric power supply device of the present invention is described with reference to FIG. 1. FIG. 1 is a perspective view showing the overall configuration of the component mounter 10 which can use the contactless electric power supply device 1 of embodiment 1 of the present invention. The component mounter 10 is a device for mounting many components onto a board, and has a configuration in which two sets of component mounting units with the same construction are arranged largely with bilateral symmetry. Here, a component mounting unit with the cover removed at the front right side of FIG. 1 is described as an example. In the figure, the width of the component mounter 10 going from the left rear side to the front right side is the X-axis direction, and the length of the component mounter 10 is the Y-axis direction.

The component mounter 10 is configured with a board conveyance device 110, a component supply device 120, two component transfer devices 130 and 140, and so on assembled to a base 190. The board conveyance device 110 is transversely in the X-axis direction around the center of the lengthwise direction of the component mounter 10. The board conveyance device 110 uses a conveyor which is omitted from the figure and conveys boards in the X-axis direction. Also, the board conveyance device 110 uses a clamp device which is omitted from the figure and secures and holds boards at a predetermined mounting work position. The component supply device 120 is provided at the front section (the left front side of FIG. 1) in the lengthwise direction of the component mounter 10. The component supply device 120 uses multiple cassette type feeders 121, and components are consecutively supplied to the two component transfer devices 130 and 140 from carrier tape set in each feeder 121.

The two component transfer devices 130 and 140 are what are known as XY-robot type devices, which can move in the X-axis direction and Y-axis direction. The two component transfer devices 130 and 140 are arranged facing each other at the front side and rear side of the component mounter 10 in the lengthwise direction. To move each of the component transfer device 130 and 140 in the Y-axis direction, there is a linear motor device 150. The linear motor device 150 comprises a support rail 155 and a track member 151 shared for the two component transfer devices 130 and 140 and a movable section 3 for each of the two component transfer devices 130 and 140. The track member 151 is arranged parallel on both sides sandwiching the movable section 3 and extends in the Y-axis direction which is the moving direction. On the internal facing surfaces of the track member 151, multiple magnets 152 are arranged in a row in the Y-axis direction. The movable section 3 is movably mounted on the track member 151.

The movable section 3 is comprised of a movable main body section 160, a X-axis rail 161, a component mounting head 170, and the like. The movable main body section 160 extends in the Y-axis direction, and an armature that generates driving force facing the magnets 152 for the track member 151 is arranged on both side surfaces. The X-axis rail 161 extends in the X-axis direction from the movable main body section 160. A end 162 of the X-axis rail 161 is connected to the movable main body section 160, and the other end 163 is movably mounted on the support rail 155, such that it moves integrally with the movable main body section 160 in the Y-axis direction.

The component mounting head 170 is mounted on the X-axis rail 161 such that it moves in the X-axis direction. Suction nozzles which are omitted from the figure are provided on the lower side of the component mounting head 170. Suction nozzles use negative pressure to pick up components from the component supply device 120 and mount them on the printed circuit board at the mounting work position. The ball screw mechanism which is omitted from the figure mounted on the X-axis rail 161 has an X-axis motor that provides the ball screw rotational movement, and drives the component mounting head 170 in the X-axis direction. The multiple electrical devices equipped on the movable section 3 in order to move the component mounting head 170 correspond to current consumers L of this invention. Further, the armature for the linear motor device 150 is also included as a current consumer L.

The component mounter 10 is also provided with a display settings device 180 for exchanging information with operators, cameras for capturing images of boards and components which are omitted from the figure, and so on.

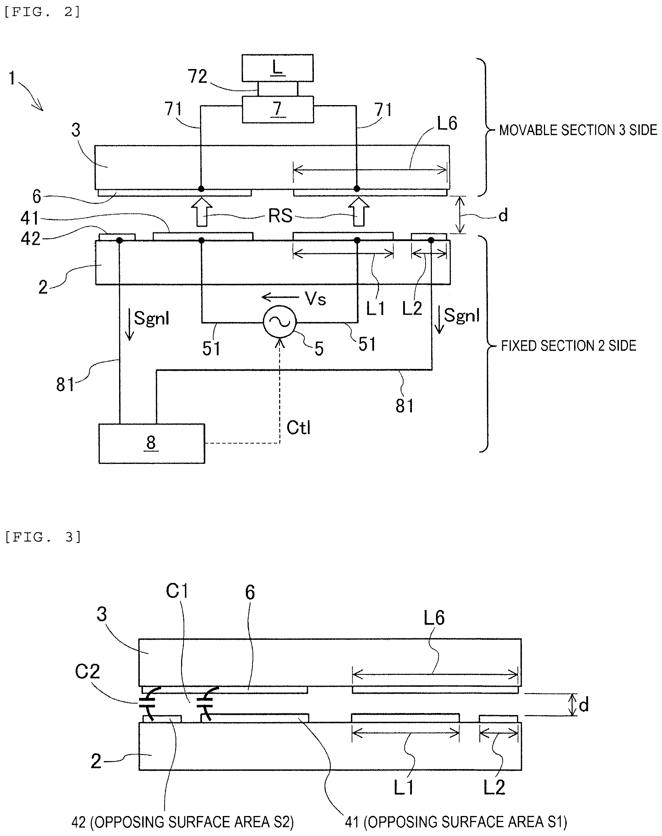

Next, the contactless electric power supply device 1 of embodiment 1 of this invention is described referencing FIG. 2 to FIG. 5. FIG. 2 is a configuration diagram to illustrate schematically the contactless electric power supply device 1 of embodiment 1. A fixed section 2 in the lower side of FIG. 2 actually comprises items such as the previously mentioned base 190 and the track member 151, but in this figure is shown simplified as thick metal plates and extending in a perpendicular direction from the page surface. The movable section 3 in the upper side also is shown simplified as thick metal plates in the figure which is different from the actual shape, and it moves in a perpendicular direction to the page surface. The contactless electric power supply device 1 is a device that provides contactless electric power by electrostatic coupling to current consumer L on the movable section 3 of the linear motor device 150 from the fixed section 2 as indicated by the white arrows RS. The contactless electric power supply device 1 is comprised of an electric power supply electrode plate 41, a reception electrode plate 42, a high-frequency power source circuit 5, a movable section side electrode plate 6, an electric power reception circuit 7, and a detection circuit 8 and the like.

The two electric power supply electrode plates 41, which correspond to the contactless electric power supply element of the present invention, are formed into long and narrow laminated bands in metal material. The two electrode power supply electrode plates 41 are provided flat on top of the fixed section 2 so that the long side of the bands extend in the moving direction (perpendicular to the page surface) of the movable section 3, and they run parallel while maintaining a distance from each other. The electric power supply electrode plates 41 short side L1 is designed to be appropriate according to the volume of the supplied electric power to be transmitted. The high-frequency power source circuit 5 is established on the fixed section 2 and is electrically connected to the two electrode power supply electrode plates 41 by electric wires 51, and supplies high-frequency electric power. The output frequency f for the high-frequency power source circuit 5 may be exemplified from the 100 kHz to MHz band, and the output voltage Vs can be adjusted, and the output voltage waveform may be exemplified by a sinusoidal wave, a rectangular wave, and the like.

The two reception electrode plates 42, which correspond to the contactless reception element of the present invention, are formed into long and narrow laminated metal material bands. As shown in FIG. 2, the two reception electrode plates 42 are provided flat on top of the fixed section 2 so that the long side of the bands extend in the moving direction (perpendicular to the page surface) of the movable section 3, and are interposed on the outside of the two electrode power supply electrode plates 41 and run parallel while maintaining a distance from each other. The two reception electrode plates 42 short side L2 is smaller than the electrode power supply electrode plates 41 short side L1 and, for example, can be approximately 10% of short side L1. The two reception electrode plates 42 are each electrically connected to the detection circuit 8 by a signal wire 81.

The two movable section side electrode plates 6, which correspond to the integrated member of the contactless electric power reception element and contactless transmitting element of the present invention, are formed into rectangular sheet shapes from metal materials and provided horizontally on the bottom surface of the movable section 3. For the movable section side electrode plates 6, the short side L6, which is perpendicular to the moving direction, is larger than the total combined value for the short sides L1 and L2 of a set of the electric power supply electrode plate 41 and the reception electrode plate 42 at the fixed section 2 side (L6 > L1 + L2), and is positioned opposite and facing both 41 and 42 while separated by separation distance d. It follows that, as shown in FIG. 3, the parallel plates form two capacitors C1, C2. FIG. 3 is a diagram to illustrate the configured capacitor C1 for transmitting electric power and the capacitor C2 for receiving for embodiment 1.

The electrostatic capacity C1 of the electric power supply capacitor C1 formed from the electric power supply electrode plate 41 and the movable section side electrode plate 6, from the formula without considering the effect of the ends, can be determined as $C1 = \varepsilon \times S1 / d$. In the same manner, the electrostatic capacity C2 of the reception capacitor C2 formed from the reception electrode plate 42 and the movable section side electrode plate 6 can be determined as $C2 = \varepsilon \times S2 / d$. Area S1 is the opposing surface area of the electric power supply electrode plate 41 and the movable section side electrode plate 6, and area S2 is the opposing surface area of the reception electrode plate 42 and the movable section side electrode plate 6, and $\varepsilon$ is the dielectric constant of the medium (air) between the electric plates. In addition, because there is no opposing surface area between the electric power supply electrode plate 41 and the reception electrode plate 42, the electrostatic capacity of the capacitor formed between both 41 and 42 is very small, and is negligible.

Returning to FIG. 2, the movable section side electrode plates 6 are each electrically connected to the input side of the electric power reception circuit 7 by a output wire 71. The electric power reception circuit 7 is provided on the movable section 3 and the output side is electrically connected to current consumer L by electric power supply wire 72. The electric power reception circuit 7 converts the high-frequency electric power received by the movable section side electrode plates 6 from the electric power supply electrode plates 41 and supplies electric power to current consumer L. The electric power reception circuit 7 generates the necessary direct current or specified frequency alternating current electric power for driving current consumer L. In embodiment 1, the electric power reception circuit 7 is comprised of a full wave rectifier circuit with a connecting bridge to four rectification diodes, and a smoothing circuit of inductor LL and capacitor CL, and supplies direct current electric power to current consumer L. The electric power reception circuit 7 can also be comprised of other inverter circuits and the like.

The detection circuit 8, which is provided on the fixed section 2, is electrically connected to the reception electrode plates 42 by the signal wire 81. The detection circuit 8 detects the operating condition of current consumer L based on the electric signal Sgnl received by the reception electrode plates 42 from the movable section side electrode plates 6.

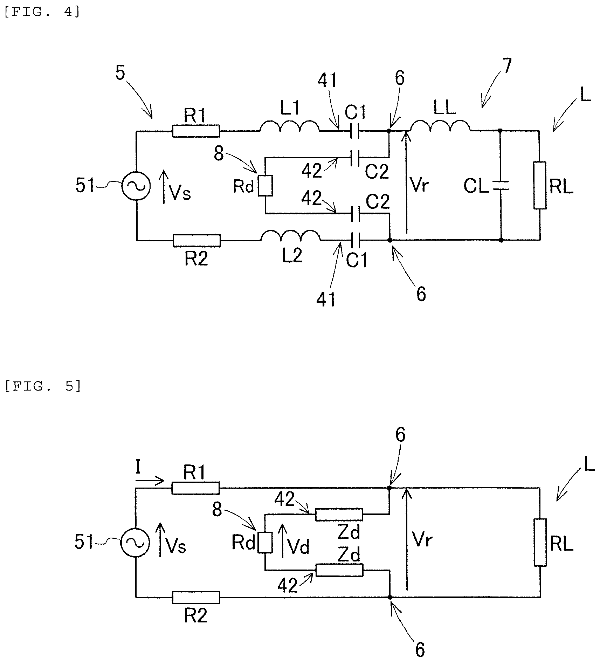

Next is described an equivalent circuit concerning the circuit configuration for the contactless electric power supply device 1 of embodiment 1 configured like that above. FIG. 4 is an equivalent circuit diagram for the contactless electric power supply device 1 of embodiment 1. Furthermore, FIG. 5 is an equivalent circuit diagram for the resonance frequency f of the contactless electric power supply device 1 of embodiment 1. In FIG. 4 and FIG. 5, the conductive resistance, stray inductance, and stray capacitance of electric wires 51, the output wires 71, electric power supply wire 72, and the signal wire 81 are omitted.

As shown in FIG. 4, the total of the six electrode plates 41, 42, and 6 are replaced with the equivalent of four capacitors C1, C2. The high-frequency power source circuit 5 is replaced with the equivalent circuit with a series connection of an ideal high-frequency power source 51, and two internal resistors R1, R2, and two internal inductors L1, L2. Because the full-wave rectifier can be omitted from consideration, the electric power reception circuit 7 is replaced with the equivalent of smoothing circuit of inductors LL and capacitors CL. In addition, current consumer L is replaced with resistance load RL, and the detection circuit 8 is replaced with detected resistance Rd. However, resistance detection Rd is set larger than resistance load RL to a degree to which it can be basically disregarded (Rd >> RL).

From this, in embodiment 1, a series resonant circuit is configured for the output frequency f for the high-frequency power source circuit 5 from the electric power supply electrode plate 41, the movable section side electrode plate 6, the high-frequency power source circuit 5, and the electric power reception circuit 7. In other words, the output frequency f becomes resonance frequency f and resonance electric power current I flows, and contactless electric power is supplied from the electric power supply electrode plate 41 to the movable section side electrode plate 6. At this time, the imaginary number section of the impedance demanded from electric power supply capacitor C1, inductors L1, L2 in the high-frequency power source circuit 5, as well as the smoothing circuit inductor LL and capacitor CL, becomes zero, and as shown in FIG. 5 these elements can omitted from consideration. On the other hand, because the receiving capacitor C2 is not related to the series resonance, the imaginary number impedance for resonance frequency f is $Zd = 1 / (j2\pi f \times C2)$. However, j is an imaginary unit.

From FIG. 5, because detected resistance Rd is negligible compared to resistance load RL, received voltage Vr that occurs at the movable section side electrode plate 6 and which is output voltage Vs of the high-frequency power source circuit 5, can be calculated by the following formula (A) for the voltage dividing.

$$Vr \fallingdotseq Vs \times RL / (RL + R1 + R2) \qquad (A)$$

Furthermore, detected voltage Vd detected between both ends of detected resistance Rd of the detection circuit 8, can be calculated by the following formula (B) for the dividing voltage.

$$Vd = Vr \times Rd / (Rd + 2 \times Zd) \qquad (B)$$

Formula (B) shows that when the output frequency f is constant, the detected voltage Vd ratio for the received voltage Vr is constant.

From this point, we are considering when the operating condition of current consumer L is changed. If current consumer L becomes heavier and resistance load RL is decreased, received formula (A) voltage Vr is decreased. Conversely, if current consumer L becomes lighter and resistance load RL is increased, received voltage Vr is increased. It follows that, received voltage Vr is the electric signal of the present invention that is related to the operating condition of current consumer L. Further, there are cases when it is necessary to consider the imaginary impedance based on the current consumer L type without replacing the simple resistance load RL, but there are no changes to the received voltage Vr changes according to the operating condition of the current consumer L, and the received voltage Vr is the electric signal of the present invention.

On the other hand, detected voltage Vd detected in the detection circuit 8 received by contactless electric power reception element 42 is a value multiplied by a constant ratio to received voltage Vr. It follows that, detected voltage Vd also is an electric signal Sgnl related to the operating condition of current consumer L.

Based on this electric signal Sgnl, the detection circuit 8 detects the operating condition of current consumer L, and adjusts the output voltage Vs of the high-frequency power source circuit 5. Specifically, the detection circuit 8 sends control signal Ctl for increasing the output voltage Vs to the high-frequency power source circuit 5 when the detected voltage Vd is reduced, and when the detected voltage Vd is increased, sends control signal Ctl for decreasing the output voltage Vs (refer to FIG. 2). The high-frequency power source circuit 5 adjusts the output voltage Vs up and down based on the control signal Ctl. From the feedback control of the above explanation, the received voltage Vr of the movable section 3 can roughly be kept constant.

According to embodiment 1 for the contactless electric power supply device 1, the electric signal Sgnl (received voltage Vr) related to the operation condition of current consumer L is transmitted in a contactless manner from the movable section side electrode plate 6 on the movable section 3 to the reception electrode plate 42 on the fixed section 2, and is detected by the detection circuit 8 on the fixed section 2. It follows that, the electric circuit on the movable section 3 can be made simpler compared to a configuration in which the detection circuit and communication circuit are on the movable section 3, and the movable section 3 can be lighter and more compact which can contribute to reducing the supplied electric power and lowering equipment costs of the component mounter 10.

in addition, for the movable section 3, because it is good to just make the movable section side electrode plate 6 larger compared to conventional configurations without increasing the quantity of parts, this can greatly contribute to reducing equipment costs. Furthermore, as well as maintaining a large electric power supply with a series resonant circuit, received voltage Vr is stable because the output voltage Vs of the high-frequency power source circuit 5 is adjusted based on the operating condition of current consumer L, sufficient electric power is supplied to the current consumer L on the movable section 3 and the stability of the operating condition is raised.

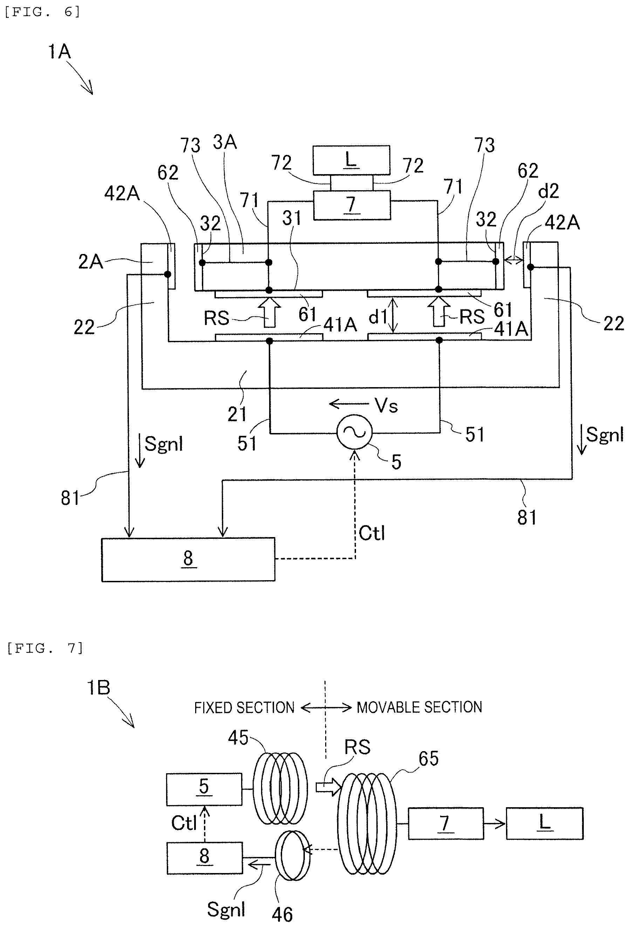

Next, embodiment 2 of a contactless electric power supply device 1A with changes to the electrode plate configuration and arrangement is described referencing FIG. 6. FIG. 6 is a configuration diagram to illustrate schematically the contactless electric power supply device 1A of embodiment 2. A fixed section 2A shown in FIG. 2 extends in a perpendicular direction from the page surface, and a movable section 3A moves in a perpendicular direction from the page surface. In addition, as indicated by the white arrows RS, contactless electric power is supplied from the fixed section 2A to the movable section 3A. In embodiment 2, instead of the movable section side electrode plate 6, a separate electrode plate for receiving electric power 61 and an electrode plate for transmitting 62 are used.

As shown in FIG. 6, in embodiment 2, the fixed section 2A is formed by thick shaped bottom section 21 and side surface section 22 that extends upwards from both end edges of bottom section 21 being integrated as one body. And, bottom section 21 is facing and separated from bottom 31 of the movable section 3A, and both side surface sections 22 are facing and separated from both side surfaces 32 of the movable section 3A.

Two electric power supply electrode plates 41A are formed into long and narrow laminated in metal material. The two electrode power supply electrode plates 41A are provided flat on top of the fixed section 2A so that the long side of the bands extend in the moving direction (perpendicular to the page surface) of the movable section 3A, and they run parallel while maintaining a distance from each other. The two electrode power supply electrode plates 41A are each electrically connected to the high-frequency power source circuit 5 by electric power wire 51. Two reception electrode plates 42A are formed into long and narrow laminated bands in metal material. The two reception electrode plates 42A are provided vertically on the inside surface upper section of side surface section 22 of the fixed section 2A so that the long side of the bands extend in the moving direction (perpendicular to the page surface) of the movable section 3. The two reception electrode plates 42A are each electrically connected to the detection circuit 8 by the signal wire 81.

The two electrode plates for receiving electric power 61, which correspond to the contactless electric power reception element of the present invention, are formed into rectangular sheet shapes from metal materials and provided horizontally on the bottom surface of the movable section 3A. The electrode plates for receiving electric power 61 are positioned parallel, face-to-face, and separated from the electric power supply electrode plates 41A by separation distance d1. It follows that, electric power supply capacitor C1 is formed from parallel plates from the electric power supply electrode plates 41A and electrode plates for receiving electric power 61. The electrode plates for receiving electric power 61 are each electrically connected to the electric power reception circuit 7 by the output wires 71.

The two electrode plates for transmitting 62, which correspond to the contactless transmitting element of this invention, are formed into rectangular sheet shapes from metal materials, and are provided vertically on both side surfaces 32 of the movable section 3A for almost the entire height. The electrode plates for transmitting 62 are positioned parallel, face-to-face, and separated from the reception electrode plates 42A by separation distance d2. It follows that, receiving capacitor C2 is formed from parallel plates from the electrode plate for transmitting 62 and the reception electrode plate 42A. Each of the electrode plates for transmitting 62 is individually electrically connected to the respective electrode plate for receiving electric power 61 by short wire 73.

For embodiment 2, items other than the above part configuration and functions are the same as those for embodiment 1, and in FIG. 6 the same reference symbols are used and descriptions are omitted. In addition, the equivalent circuit for embodiment 2 also uses FIG. 3 and FIG. 4 descriptions in the same manner as embodiment 1, and because the operation and effects are the same as embodiment 1, these descriptions are omitted.

Next, embodiment 3 using electromagnetic coupling type for a contactless electric power supply device 1B is described referencing FIG. 7. FIG. 7 is a configuration diagram to illustrate conceptually the contactless electric power supply device 1B of embodiment 3. The left side of FIG. 7 shows the circuit of the fixed section side, and the right side shows the circuit of the movable section side. In addition, as indicated by the white arrow RS, contactless electric power is supplied from the fixed section to the movable section. For embodiment 3, coils are used instead of electrode plates.

As shown in FIG. 7, in embodiment 3, an electric power supply coil 45, a reception coil 46, the high-frequency power source circuit 5, and the detection circuit 8 are provided on a fixed section. The electric power supply coil 45 corresponds to contactless electric power supply element, and is electrically connected to the high-frequency power source circuit 5 and supplies high-frequency electric power. The reception coil 46 corresponds to contactless reception element, and is smaller than the electric power supply coil 45. The reception coil 46 is electrically connected to the detection circuit 8, and transmits the electric signal that is received in a contactless manner from a later mentioned movable section side coil 65.

On the other side, the movable section side coil 65, the electric power reception circuit 7, and current consumer L are provided on the movable section. The movable section side coil 65 corresponds to the integrated member of the contactless electric power reception element and contactless transmitting element. The movable section side coil 65 is positioned facing and separated from the electric power supply coil 45 and the reception coil 46 on the fixed section side, and has satisfactory electromagnetic coupling with both 45 and 46. The movable section side coil 65 is electrically connected to the input side of the electric power reception circuit 7, and the output side of the electric power reception circuit 7 is electrically connected to current consumer L. Between the electric power supply coil 45 and the movable section side coil 65 there is a large coefficient of mutual induction and contactless electric power supply becomes possible, and electric power is supplied to current consumer L.

On the other hand, between the movable section side coil 65 and the reception coil 46 there is also a relatively large coefficient of mutual induction, and the electric signal Sgnl can be transmitted from the movable section to the fixed section. Detailed descriptions for the equivalent circuit are omitted, but the electric signal for embodiment 3 is the induced voltage generated by the movable section side coil 65, and this induced voltage changes based on changes in the operating state of current consumer L. In addition, the electric signal Sgnl proportional to the above electric signal is detected at the reception coil 46, and is transmitted to the detection circuit 8. The detection circuit 8 sends a control signal Ctl for adjusting the output voltage based on electric signal Sgnl to the high-frequency power source circuit 5.

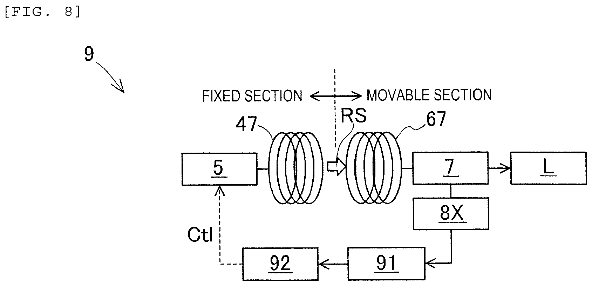

The following is a description of the effectiveness of embodiment 3 of the contactless electric power supply device 1B compared to conventional technology. FIG. 8 is a configuration diagram to exemplify conceptually a conventional technology contactless electric power supply device 9. The left side of FIG. 8 shows the circuit of the fixed section side, and the right side shows the circuit of the movable section side. In addition, as indicated by the white arrow RS, contactless electric power is supplied from the fixed section to the movable section.

As shown in FIG. 8, in conventional technology, a electric power supply coil 47 is equipped on the fixed section, and an electric power reception coil 67 is equipped on the movable section, and contactless electric power supply is performed between both of the coils 47 and 67. The electric signal related to the operating condition of the current consumer L is detected at a detection circuit 8X which is provided on the movable section side. Also, a transmitting circuit 91 is provided on the movable section side, and a receiving circuit 92 is provided on the fixed section side, and the electric signal is transmitted to the fixed section by communication.

As can be clearly seen in FIG. 7 compared to FIG. 8, in embodiment 3, the movable section side detection circuit 8X and transmitting circuit 91 are not present and the electric circuit can be simplified, and the movable section can be lighter and more compact which can contribute to reducing the supplied electric power and lowering equipment costs.

In the present invention, electric power is supplied from the fixed section to the movable section and an electric signal is transmitted from the movable section to the fixed section, and it is possible to combine an electrostatic coupling type and an electromagnetic induction type in a case wher the contactless electric power supply element and contactless electric power reception element are electrode plates and supply electric power by electrostatic coupling, and the contactless transmitting element and contactless reception element are coils and the electric signal is transmitted by electromagnetic induction. However, conversely, electric power being supplied by electromagnetic induction and the electric signal being transmitted by electrostatic coupling does not fall within the scope of the invention. Various other applications and modifications are possible for the present invention, which is defined by the claims.

Industrial Applicability

The present invention of a contactless electric power supply device can be employed in a component mounter, and can be employed in other board manufacturing equipment such as a board inspection machine. Further, the present invention of a contactless electric power supply device can also be used as a means for driving power for items other than linear motor devices, for example it can be used in various devices for driving power of movable sections in ball screw driven devices.

Reference Signs List

1, 1A, 1B: Contactless electric power supply device
2, 2A: Fixed section
3, 3A: Movable section
41, 41A: Electric power supply electrode plate (contactless electric power supply element)
42, 42A: Reception electrode plate (contactless reception element)
45: Electric power supply coil (contactless electric power supply element)
46: Reception coil (contactless reception element)
5: High-frequency power source circuit
51: High-frequency voltage source
6: Movable section side electrode plate
61: Electrode plate for receiving electric power (contactless electric power reception element)

62: Electrode plate for transmitting (contactless transmitting element)
65: Movable section side coil
7: Electric power reception circuit
8: Detection circuit
9: Conventional technology contactless electric power supply device
10: Component mounter
110: Board conveyance device
120: Component supply device
130, 140: Component transfer device
150: Linear motor device
160: Movable main body section
161: X-axis rail
170: Mounting head
180: Display settings device
190: Base
L: Current consumer
RL: Resistance load
Rd: Detected resistance
Vs: Output voltage
Vr: Received voltage
Vd: Detected voltage
Sgnl: Electric signal

**Claims**

1. A contactless electric power supply device (1, 1A, 1B) for capacitive power transfer comprising:

a contactless electric power supply element (41, 41A, 45) provided on a fixed section (2, 2A), a high-frequency power source circuit (5) configured to supply high-frequency electric power to the contactless electric power supply element (41, 41A, 45), a contactless electric power reception element (6, 61, 65) which is facing and separated from the contactless electric power supply element (41, 41A, 45) and configured to receive the high-frequency electric power in a contactless manner and which is provided on a movable section (3, 3A) that is movably mounted on the fixed section (2, 2A), an electric power reception circuit (7) configured to supply electric power to a current consumer (RL) on the movable section (3, 3A) after converting the high-frequency electric power which the contactless electric power reception element (6, 61, 65) received, a contactless transmitting element (6, 62, 65) provided on the movable section (3, 3A), a contactless reception element (42, 42A, 46) provided on the fixed section (2, 2A) which is facing and separated from the contactless transmitting element (6, 62, 65) and configured to receive electric signals (Sgnl) related to operating condition of the current consumer (RL) in a contactless manner but is not electrically connected to the contactless electric power supply element (41, 41A, 45) so that it does not transmit the high-frequency electric power to the contactless transmitting element (6, 62, 65), and
a detection circuit (8) which is provided on the fixed section (2, 2A) and that is configured to detect the operating condition of the current consumer (RL),

**characterized in that**

the contactless transmitting element (6, 62, 65) is electrically connected to the contactless electric power reception element (6, 61, 65), and the detection circuit (8) is electrically connected to the contactless reception element (42, 42A, 46), and configured to detect the operating condition of the current consumer (RL) based on the electric signal (Sgnl).

2. The contactless electric power supply device (1, 1B) according to claim 1, wherein the contactless electric power reception element (6, 65) and the contactless transmitting element (6, 65) are integrated in one electrode plate on the movable section (3A) side.

3. The contactless electric power supply device (1, 1A, 1B) according to claim 1 or 2, wherein the detection circuit (8) is configured to adjust the output voltage of the power source circuit (5) based on the detected operating condition of the current consumer (RL).

4. The contactless electric power supply device (1, 1A, 1B) according to any of the claims from 1 to 3, wherein a series resonant circuit for the output frequency of the high-frequency power source circuit (5) is configured from the contactless electric power supply element (41, 41A, 45), the contactless electric power reception element (6, 61, 65), the high frequency power source circuit (5), and the electric power reception circuit (7).

5. The contactless electric power supply device (1, 1A, 1B) according to any of the claims from 1 to 4, wherein the movable section (3, 3A) is provided in a component mounter (10) for mounting components on a circuit board, and is further provided with a mounting head (170) for performing component mounting actions.

**Patentansprüche**

1. Eine kontaktfreie Stromübertragungsvorrichtung (1, 1A, 1B) für kapazitative Stromübertragung umfassend:

ein kontaktloses elektrisches Stromversorgungselement (41, 41A, 45), das an einem festen Abschnitt (2, 2A) angeordnet ist,
eine Hochfrequenz-Stromquellenschaltung (5), die konfiguriert ist dem kontaktlosen elektrischen Stromversorgungselement (41, 41A, 45) elektrischen Hochfrequenz-Strom zuzuführen,
ein kontaktloses elektrisches Stromempfangselement (6, 61, 65), das dem kontaktlosen elektrischen Stromversorgungselement (41, 41A, 45) gegenüberliegt und von diesem getrennt ist und konfiguriert ist den hochfrequenten elektrischen Strom kontaktlos zu empfangen, und das an einem beweglichen Abschnitt (3, 3A) angeordnet ist, der beweglich an dem festen Abschnitt (2, 2A) angebracht ist,
eine Stromempfangsschaltung (7), die konfiguriert ist einen Stromverbraucher (RL) auf dem beweglichen Abschnitt (3, 3A) mit Strom zu versorgen, nachdem sie den elektrischen Hochfrequenz-Strom, den das kontaktlose Stromempfangselement (6, 61, 65) empfangen hat, umgewandelt hat
ein kontaktloses Sendeelement (6, 62, 65), das auf dem beweglichen Abschnitt (3, 3A) angeordnet ist,
ein kontaktloses Empfangselement (42, 42A, 46), das an dem festen Abschnitt (2, 2A) angeordnet ist, das dem berührungslosen Sendeelement (6, 62, 65) zugewandt und von diesem getrennt ist und konfiguriert ist elektrische Signale (Sgnl), die sich auf den Betriebszustand des Stromverbrauchers (RL) beziehen, berührungslos zu empfangen, aber nicht elektrisch mit dem berührungslosen elektrischen Stromversorgungselement (41, 41A, 45) verbunden zu sein, so dass es den elektrischen Hochfrequenz-Strom nicht an das berührungslose Sendeelement (6, 62, 65) überträgt, und
eine Erfassungsschaltung (8), die an dem festen Abschnitt (2, 2A) angeordnet ist und die konfiguriert ist, den Betriebszustand des Stromverbrauchers (RL) zu erfassen,

**gekennzeichnet dadurch, dass**

das kontaktlose Sendeelement (6, 62, 65) elektrisch mit dem kontaktlosen Stromempfangselement (6, 61, 65) verbunden ist, und
die Erfassungsschaltung (8) elektrisch mit dem kontaktlosen Empfangselement (42, 42A, 46) verbunden ist und konfiguriert ist den Betriebszustand des Stromverbrauchers (RL) basierend auf dem elektrischen Signal (Sgnl) zu erfassen.

2. Die kontaktfreie Stromübertragungsvorrichtung (1, 1B) gemäß Anspruch 1, wobei
das kontaktlose Stromempfangselement (6, 65) und das kontaktlose Sendeelement (6, 65) in einer Elektrodenplatte auf der Seite des beweglichen Abschnitts (3A) integriert sind.

**3.** Die kontaktfreie Stromübertragungsvorrichtung (1, 1B) gemäß Anspruch 1 oder 2, wobei die Erfassungsschaltung (8) konfiguriert ist die Ausgangsspannung der Stromquellenschaltung (5) auf der Grundlage des erfassten Betriebszustands des Stromverbrauchers (RL) anzupassen.

**4.** Die kontaktfreie Stromübertragungsvorrichtung (1, 1B) gemäß einem der Ansprüche 1 bis 3, wobei aus dem kontaktlosen Stromversorgungselement (41, 41A, 45), dem kontaktlosen Stromempfangselement (6, 61, 65), der Hochfrequenz-Stromquellenschaltung (5) und der Stromempfangsschaltung (7) ein Serienschwingkreis für die Ausgangsfrequenz der Hochfrequenz-Stromquellenschaltung (5) gebildet wird.

**5.** Die kontaktfreie Stromübertragungsvorrichtung (1, 1B) gemäß einem der Ansprüche 1 bis 4, wobei der bewegliche Abschnitt (3, 3A) in einem Bauteilhalter (10) zum Montieren von Bauteilen auf einer Leiterplatte angeordnet ist und ferner mit einem Montagekopf (170) zur Durchführung von Bauteilmontagevorgängen versehen ist.

**Revendications**

**1.** Dispositif d'alimentation électrique sans contact (1, 1A, 1B) pour un transfert de puissance capacitif, comprenant :

un élément d'alimentation électrique sans contact (41, 41A, 45) pourvu sur une section fixe (2, 2A),
un circuit de source d'alimentation haute fréquence (5) configuré pour fournir une alimentation électrique haute fréquence à l'élément d'alimentation électrique sans contact (41, 41A, 45),
un élément de réception d'alimentation électrique sans contact (6, 61, 65) qui fait face à l'élément d'alimentation électrique sans contact (41, 41A, 45) et est séparé de celui-ci et configuré pour recevoir l'alimentation électrique haute fréquence sans contact, et qui est pourvu sur une section mobile (3, 3A) montée de façon mobile sur la section fixe (2, 2A),
un circuit de réception d'alimentation électrique (7) configuré pour fournir une alimentation électrique à un consommateur de courant (RL) sur la section mobile (3, 3A) après la conversion de l'alimentation électrique haute fréquence que l'élément de réception d'alimentation électrique sans contact (6, 61, 65) a reçue,
un élément de transmission sans contact (6, 62, 65) pourvu sur la section mobile (3, 3A),
un élément de réception sans contact (42, 42A, 46) pourvu sur la section fixe (2, 2A) qui fait face à l'élément de transmission sans contact (6, 62, 65) et est séparé de celui-ci et configuré pour recevoir des signaux électriques (Sgnl) relatifs à l'état de fonctionnement du consommateur de courant (RL) sans contact mais sans être connecté électriquement à l'élément d'alimentation électrique sans contact (41, 41A, 45) de sorte qu'il ne transmet pas l'alimentation électrique haute fréquence à l'élément de transmission sans contact (6, 62, 65), et
un circuit de détection (8) qui est pourvu sur la section fixe (2, 2A) et configuré pour détecter l'état de fonctionnement du consommateur de courant (RL),
**caractérisé en ce que**
l'élément de transmission sans contact (6, 62, 65) est connecté électriquement à l'élément de réception d'alimentation électrique sans contact (6, 61, 65), et
le circuit de détection (8) est connecté électriquement à l'élément de réception sans contact (42, 42A, 46) et configuré pour détecter l'état de fonctionnement du consommateur de courant (RL) sur la base du signal électrique (Sgnl).

**2.** Dispositif d'alimentation électrique sans contact (1, 1B) selon la revendication 1, dans lequel l'élément de réception d'alimentation électrique sans contact (6, 65) et l'élément de transmission sans contact (6, 65) sont intégrés dans une plaque d'électrode du côté de la section mobile (3A) .

**3.** Dispositif d'alimentation électrique sans contact (1, 1A, 1B) selon la revendication 1 ou 2, dans lequel le circuit de détection (8) est configuré pour ajuster la tension de sortie du circuit de source d'alimentation (5) sur la base de l'état de fonctionnement détecté du consommateur de courant (RL).

**4.** Dispositif d'alimentation électrique sans contact (1, 1A, 1B) selon l'une quelconque des revendications 1 à 3, dans lequel un circuit résonnant série pour la fréquence de sortie du circuit de source d'alimentation haute fréquence (5) est configuré par l'élément d'alimentation électrique sans contact (41, 41A, 45), l'élément de réception d'alimentation électrique sans contact (6, 61, 65), le circuit de source d'alimentation haute fréquence (5) et le circuit de réception d'alimentation électrique (7).

**5.** Dispositif d'alimentation électrique sans contact (1, 1A, 1B) selon l'une quelconque des revendications 1 à 4, dans lequel la section mobile (3, 3A) est pourvue dans un dispositif de montage de composants (10) pour monter des composants sur un circuit imprimé, et est en outre pourvue d'une tête de montage (170) pour mettre en œuvre des actions de montage de composants.

[FIG. 1]

[FIG. 2]

[FIG. 3]

42 (OPPOSING SURFACE AREA S2)   41 (OPPOSING SURFACE AREA S1)

[FIG. 4]

[FIG. 5]

[FIG. 6]

1A

[FIG. 7]

1B

FIXED SECTION ⟵ ⟶ MOVABLE SECTION

[FIG. 8]

FIXED SECTION ⟷ MOVABLE SECTION

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011223739 A

- WO 2012070479 A1

**Non-patent literature cited in the description**

- **T.BIELER et al.** Contactless power and information transmission. *IEEE TRANSACTIONS ON INDUS-TRY APPLICATIONS.*, September 2002, vol. 38 (5), ISSN 0093-9994, 1266-1272